# EUROPEAN PATENT SPECIFICATION

(11) **EP 2 068 609 B1**
(45) Date of publication and mention of the grant of the patent: **21.08.2013**
(21) Application number: 08170460.3
(22) Date of filing: 02.12.2008
(51) Int. Cl.: G06F 1/20, G05D 23/19, H05K 7/20

(54) **Method for controlling the speed of a fan using a measurement of the ambient noise and electronic device implementing the method**
Verfahren zur Geschwindigkeitssteuerung eines Lüfters durch Messung des Umgebungslärms und dieses Verfahren implementierende elektronische Vorrichtung
Procédé de contrôle de la vitesse d'un ventilateur utilisant la mesure d'un bruit ambiant et dispositif électronique mettant en oeuvre le procédé

(30) Priority: 04.12.2007 FR 0759552
(43) Date of publication of application: 10.06.2009
(73) Proprietor: Thomson Licensing, 92130 Issy-les-Moulineaux (FR)
(72) Inventor: Mace, PHILIPPE, 92648, BOULOGNE CEDEX (FR); Guitton, Xavier, 92648, BOULOGNE CEDEX (FR); Benezeth, Philippe, 92648, BOULOGNE CEDEX (FR)
(74) Representative: Arnold, Klaus-Peter

(56) References cited:
- WO-A-02/51228
- WO-A2-2006/046179
- US-A1- 2004 267 990

## Description

The present invention relates to a method for controlling the speed of a fan using the measurement of the ambient sound. The present invention also relates to a device equipped with a microphone and a fan.

The electronic devices consume a great deal of energy during normal operation. This energy is transformed into heat that is concentrated within devices that are generally sealed. If it is not evacuated this heat provokes an accelerated aging of electronic components that results in irreversible deterioration. To prevent this, manufacturers cut air inlets in the casing of the device enabling an evacuation of hot air. A fan is arranged near the inlets to accelerate the exchanges with the exterior and enable the cooling of the internal components. But using a fan at full speed is noisy. If the device is a television decoder for example, it can be placed in a bedroom. In this case, it must not disturb the sleep of the users; the maximum threshold usually allowed is twenty-five decibels.

To reduce the sound level, the control system of the fan regularly checks the speed and the module according to a set value to attain. A temperature probe is placed in a usually warm location of the device. As soon as a temperature threshold is reached or exceeded, the speed of the fan increases in proportion to the difference between the temperature threshold and the value measured by the probe. Typically, the fan is switched on at a slow speed when the device is powered up, and as soon as the temperature exceeds 50°C within the device, the speed of the fan is increased. Usually, several temperature thresholds are used; the control system calculates the control value according to these thresholds. To control its operation, the fan has a tachymetric probe that sends a signal according to the real speed of the blades. The control unit of the fan analyses the signals coming from the tachymetric probe and regularly control the speed of the fan. The control is carried out by an automated system of the PID (P for proportional, I for Integral and D for Derivative). This automated system enables a precise control of the speed, by adjusting the command given to the fan according to a set value calculated from the values measured by the tachymetric probe.

As electronic components find it difficult to support excessive heat, designers are confronted with the following dilemma: either to privilege the absence of noise and risk overheating the components, or to ventilate the interior of the device as well as possible but making it noisy.

US 2004/0267990 describes a portable computer with a heat dissipating module comprising a fan. The fan causes a certain noise level. The portable computer includes a microphone, which is used to measure surrounding noises. The fan is controlled based on a measured temperature and the measured surrounding noises.

WO 2006/046179 describes a method for controlling a noise producing component, such as a fan. An output level of a rendered audio signal is measured. When the output level is low, the noise producing component is controlled such that the generated noise is lowered, e.g. by reducing the speed of the fan.

It is an object of the present invention to propose an improved solution for controlling the speed of a fan.

This object is achieved by a method and a system as defined by the appended independent claims.

Advantageous refinements of the invention are described in the dependent claims.

One of the purposes of the present invention is a method for controlling the speed of a fan equipping an electronic device by means of a command value, the device comprising a means for transmitting a sound signal, comprising a command step of the fan by applying a first command value,
the method being characterized in that it comprises
- a measurement step of the ambient sound level, the measurement step being performed in a remote control dedicated to the electronic device,
- an increase step of the speed of the fan by applying a second command value to the fan when the ambient sound level exceeds a determined value,
- a detection step of the reduction in the amplitude of the sound signal transmitted by the device triggering the application of the first command value to the fan.

In this manner, when the ambient sound level at the location of the remote control covers the noise of the fan, said fan can run at a high speed in such a manner as to correctly ventilate the inside of the device and thus protects the electronic components. When the device detects a reduction in the amplitude of the sound signal transmitted by the device, then the device can assume that this sound signal is the signal that is responsible for the sound environment. It then applies, by anticipation, an immediate drop in the control speed at the fan. As the measurement means of the sound level is placed in the remote control, the remote control sends the device a signal representative of the amplitude of the ambient sound level.

According to a first variant, the detection step of the reduction of the sound signal transmitted in the device consists in detecting the introduction of a reduction command of the sound level controlled by the device. Hence, the manual introduction of a reduction command gives an immediate return to the command value initially calculated. According to a second variant, the detection step of the reduction of the sound signal transmitted in the device consists in detecting the reduction of the amplitude of a sound signal at the level of an input connector of the device. In this case, it is the analysis of the amplitude of a sound signal applied at the input of the device that enables the reduction of the sound signal transmitted by the device to be detected. In this manner, it is possible to anticipate the drop in the ambient sound volume that the microphone will probably detect in the coming moments, and thus enable the drop in the speed of the fan to be made inaudible.

According to one improvement, the increase consists in applying to the fan a command value that is a function of the ambient sound level measured. In this manner, the sound generated by the fan is just covered by the ambient sound. According to a variant, the increase consists in applying a fixed value to the fan when the ambient sound level exceeds a determined value. In this manner, as soon as the acoustic level is exceeded, the fan operates at great speed which enables the best possible cooling.

According to an improvement, the device comprises a device for generating sound signals whose volume can be adjusted. When a user enters a command to reduce the sound level then, the command value applied to the fan is the one calculated according to the temperature, that is to say without increase. In this manner, it is possible to anticipate a drop in the sound volume when the device is the source of the ambient noise. According to an improvement, the method comprises a timeout step triggered when the command is introduced, the end of the timeout triggering the execution of the reduction command of the sound level. In this manner, it is possible to cover the reduction of the speed of the fan.

According to another improvement, the first command value applied to the fan is a function of the temperature measured in the device. In this manner, if the environment contains no sound, it is according to the internal temperature of the device that the rotation speed of the fan is calculated.

The purpose of the present invention is also a system comprising an electronic device and a remote control, the electronic device comprising a fan, a means for controlling the speed of said fan by applying a first command value, and a means for transmitting a sound signal,
characterized in that the electronic system further comprises a means for measuring the ambient sound level located on the remote control, the remote control transmitting a signal to the device representative of an amplitude of the ambient sound level, the control means increasing the speed of the fan by applying a second command value when the sound level exceeds a determined threshold, and a means for detecting the reduction in the amplitude of the sound signal transmitted by the device triggering the application of the first command value to the fan.

Other characteristics and advantages of the present invention will emerge from the description of the following embodiments to be taken as non-restrictive examples, made with reference to the annexed figures wherein:
- figure 1 shows a section of an electronic device according to an embodiment of the invention,
- figure 2 illustrates a control system according to a preferred embodiment.
- figure 3 shows a flowchart of the main steps of the method according to an embodiment of the invention.

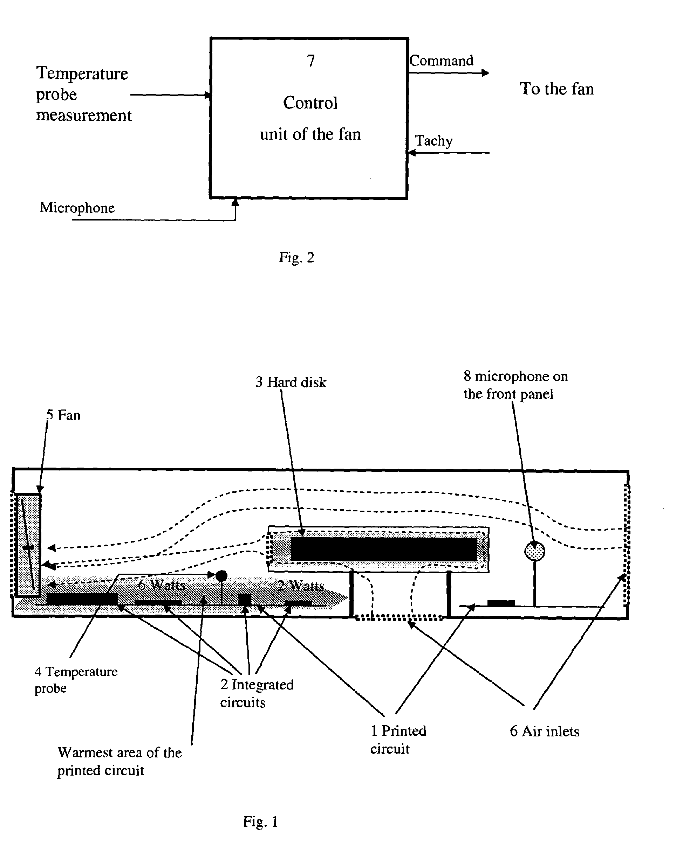

Figure 1 describes a section of an electronic device, a television decoder for example. The device comprises a printed circuit 1 on which the electronic circuits 2 are arranged. A hard disk 3 enables recording of data, particularly of lengthy audiovisual works. The circuits 2 and the disk 3 consume a lot of energy and release heat, for example, the central unit of the decoder releases an energy of approximately 6 Watts. As a result, certain zones of the decoder, marked in grey on the figure 1, are warmer than others. A temperature probe 4 arranged within one of these warm zones, preferably near to the circuit consuming the most energy, supplies a voltage proportional to the temperature. A fan 5 extracts hot air from the decoder cavity. Two ventilation air-inlets 6 cut into the decoder casing enable two cool air inlets. Curved arrows show the path of the air flows. The number, the position and the size of the air-inlets are important elements of good ventilation, these parameters being well known to those skilled in the art. A microphone 8 is arranged on the front panel in such a manner that it captures the noises of the environment of the decoder.

Figure 2 illustrates a control system according to a preferred embodiment. This figure can be applied to any control system that, receiving a measurement value and according to a set value, determines a command value. The temperature probe 4, the fan 5 and the microphone of the remote control dedicated to the electronic device are connected to a control unit 7. The control unit can be a microcontroller dedicated to regulating the temperature. The control unit 7 can also be a part of the central unit. Irrespective of its nature, the control unit has at least two analogue inputs for the reception of the signals coming from the temperature probe 4 and the microphone , one digital input for the reception of signals representative of the speed of the fan (these signals are generally called "Tachy") and one command output for the control of the fan 5. According to the measurement carried out on the probe 4, the Tachy signals and the sound volume captured by the microphone , the microcontroller 7 determines the speed of the fan to create a flow of fresh air sufficient to maintain the inside of the decoder below a nominal temperature.

In the embodiment, the fan is controlled by an analogue signal that directly controls the rotation speed of the fan. Advantageously, the control unit 7 supplies a PWM (Pulse Width Modulator) signal. It is a periodical digital signal that, converted into an analogue signal by using a low-pass filter, enables a motor to be controlled. The variation of the cyclic ratio enables the amplitude of the motor control analogue signal to be varied. In the embodiment, the cyclic ratio of the PWM is coded on 8 bits and the DC voltage applied to the fan typically varies from 0 to 5 Volts. The Tachy signal is a pulse signal, the number of pulses per unit of time determines the real speed of the fan. The audio signal coming from the microphone 8 arranged on the front panel of the electronic device is an analogue signal, it is filtered by a low-pass filter.

Measurements have shown a correlation between a decibel number and a given speed, and so a control value Vfan applied to the fan. For certain speeds, the noise seems to be controlled well; if there is a sudden change in this speed, the noise becomes audible. A regulation directly controlling the motor according to the temperature could ensure a constant temperature, but the large variations in speed would be acoustically perceptible, and in some cases, the command must be maximum which would trigger a continuous noisy operation. Therefore, the control of the fan is carried out by the PID type control system. According to the temperature measured in the device, a command value Vcom of rotation speed is determined by a control system. With time, the performances of the fan change. Therefore, the regulation system measures the speed of the fan using the tachymetric probe to determine the difference with respect to the set speed, this difference is called an error to compensate. The control system controls the voltage applied to the motor so that the speed of the fan is as close as possible to the set speed. The variations of speed must be reduced so that the users do not hear them. Nevertheless, it is necessary to ensure a good ventilation of the device in such a manner that the electronic components 2 do not heat up too much. The present invention enables the best possible ventilation to be provided at least at certain times of the operation of the device.

After describing the elements composing the device and the control system, it will now be shown how these elements co-operate.

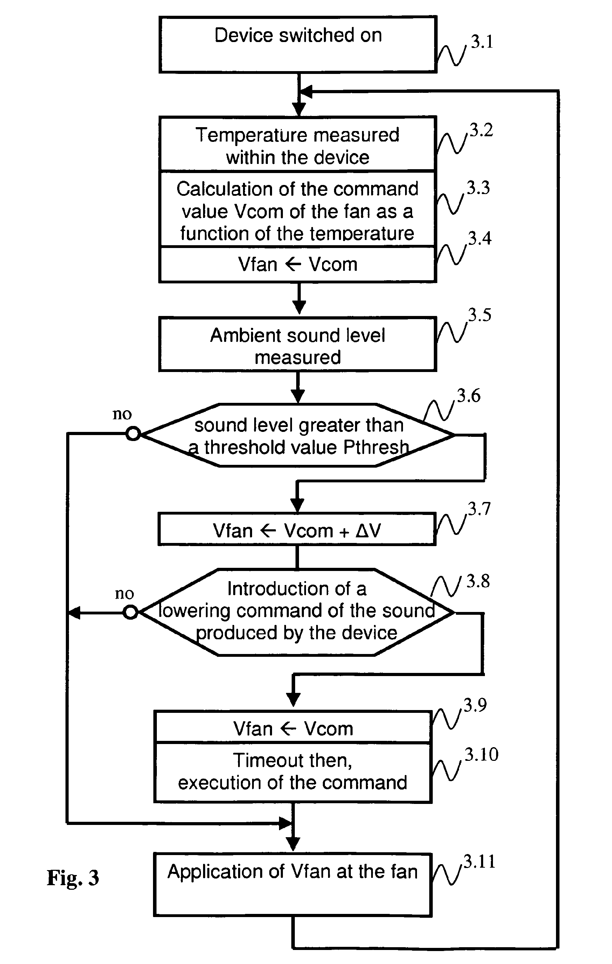

Figure 3 shows a flowchart of the different steps according to a preferred embodiment. In step 3.1, the device is switched on. The control system 7 illustrated by figure 2 is powered up. The system measures the temperature by means of the probe 4 (step 3.2) and calculates the value of the command parameter Vcom of the fan as a function of the measured temperature value (step 3.3). The maximum value of Vcom is calculated in such a manner that the noise generated by the fan does not exceed a sound level greater that the level allowed in all circumstances: 25 decibels. Hence, the calculated speed, by only taking into account the temperature, is limited to a certain value. In step 3.4, the value Vcom is the value Vfan that will be applied to the fan. Then, the system measures the ambient sound level captured by the microphone of the remote control (step 3.5).

Recall several acoustic measurement values. The acoustic power measured in a calm environment is around 25 to 30 dBA. As soon as people talk in a room, or a loudspeaker is switched on, the level rises to above 45 dBA, and can reach 60 dBA (even more with young people!). Generally, a fan has a dynamic ranging from 20 dBA to 45 dBA. In our implementation example, the fan generates an acoustic power of 39 dBA at maximum speed. In step 3.5, the measured value is compared with a threshold value: Pthresh. If the measurement is carried out in decibels and knowing that the device must not produce a sound greater than 25 decibels, if the sound level at the location of the remote control is greater than Pthresh then the fan can operate above the maximum speed allowed, as the sound of the fan is covered by the ambient sound at the location of the remote control. Therefore, the speed of the fan can be increased above the setting calculated according to the temperature, the increase being carried out within the limit that the total audible noise remains that of the ambient sound level. Recall that the sound volume resulting from the addition of several noises is calculated by the quadratic sum of the sound volumes of each noise. Take the following examples:

| | | | | |
|---|---|---|---|---|
| Ambient sound level: | 31 dBA | 35 dBA | 45 dBA | 45 dBA |
| Sound level of the fan | 25 dBA | 25 dBA | 35 dBA | 39 dBA |
| Total noise level | 32 dBA | 35.3 dBA | 45.04 dBA | 46 dBA |

For 6 dBA of difference between the ambient sound and the noise generated by the fan, the total noise increases by 1 dBA. If the difference is 10 dBA, the total sound only increases by 0.3 dBA. Experience shows that an increase of 1 dBA is not audible and that it is possible to tolerate a difference of 6 dBA between the sound generated by the fan and the ambient sound. Therefore, the higher the ambient sound level the more the speed of the fan can be increased with, as the rule, a minimum difference of 6 dBA.

According to a simple embodiment, if the acoustic power measured is greater than Pthresh = 25 dBA + 6dBA = 31 dBA, then the control system increases the command value of the fan Vfan (step 3.7), the increase consists in adding a value ΔV to Vcom previously calculated. The value ΔV is calculated according to the acoustic power measured, in such a manner that the rule of the 6 dBA is applied in all cases. The command value applied to the fan is the value for which the fan emits a sound of 6 dBA less than the one of the ambient sound measured, provided that this value is greater than Vcom calculated according to the measured temperature.

According to an embodiment variant, the control system tests whether the acoustic power is greater than 45 dBA (Pthresh = 45 dBA), in this case the increase consists in applying the high value Vhigh without taking into account the value Vcom previously calculated by the control system. By applying the high value Vhigh to it, the fan generates a new sound level of 39 decibels that is in any case covered by the ambient noise.

According to a simple embodiment, the control system can then apply the value Vfan to the fan. In the case where the device is equipped with a sound production means, for example: a decoder, an audio amplifier, a home cinema, etc. it is probable that the ambient sound measured at the location of the remote control is indeed the sound produced by the device. According to an improvement, in step 3.8, the system tests whether a lower sound command is applied to the device. If the user decides to drop the sound manually, or even cut it off, the fan can become audible for a short time. The command is either the sound volume lowering, or a total cut off of the sound (MUTE button). Owing to the inertia of the fan, the user can hear the reduction in the speed of the fan, just after the execution of the sound lowering command. According to the improvement, the introduction of the sound lowering command immediately triggers the application of the command value Vcom previously calculated by the system to the fan (step 3.8). Experiments have shown that the passage from the maximum speed Vmax to the speed Vcom is carried out in a maximum of 500 milliseconds. According to an improvement, the control system triggers a timeout that starts when the sound lowering command is received and thus at the transmission to the fan of the speed reduction command. It is at the end of this timeout that the sound lowering command is executed (step 3.10). The timeout is typically of 500 milliseconds, in this manner, the sound produced by the device up to the execution of the drop in sound level is certain to cover that of the fan.

In some cases the device does not have a means of introducing a reduction of the sound volume, but transmits a sound signal capable, after amplification of creating the sound environment of the room. In this case, it is sufficient to analyse the amplitude of the sound signal transmitted to detect a reduction. The detection is carried out at the level of the input connector of the device, or at the level of any circuit transmitting the sound signal in the device. This variant of the solution where the user manually introduces a command, is notably applicable for any device amplifying a sound signal and that is not equipped with a manual setting of the sound volume but that transmits the sound signal intended to be reproduced on loudspeakers. In the same manner as above, the detection of a drop in the sound signal transmitted immediately triggers the application at the fan of the command value Vcom previously calculated by the system in step 3.8. In the same manner, it is possible to provide for a time to apply the reduction of the signal at the output of the device to cover at least one part of the deceleration of the fan.

In step 3.11, the value Vfan is applied to the fan and the programme loops back to step 3.2 to analyse the ambient sound level again.

According to the invention, the microphone is not installed in the device but at the level of the remote control. Indeed, the remote control is assumed to be placed near the users or to be easily accessible by them. It is therefore possible to enter the ambient sound level at their levels. The remote control is equipped with a microphone, an analogue-to-digital converter enabling an item of data representative of the ambient sound level to be supplied. If the ambient sound level is greater than the threshold level, then a signal is sent by the remote control indicating that the fan can operate at a greater speed. If the device dedicated to this remote control receives the signal then it can apply the speed increase. If the communication is not possible between the remote control and the device, for example because the IR beam is poorly directed, the device will not carry out the increase.

According to a variant of the sequences of the steps, the control system first measures the ambient noise and if this noise exceeds a sound level such that the noise of the fan at maximum speed is controlled at its maximum speed. In the embodiment, the noise generated by the fan at maximum speed is 35 dBA, if the measurement of the ambient noise is 6 dBA greater, namely 41 dBA then the fan can be controlled at its maximum speed.

According to an improvement, the control system is connected to a light indicator, an LED diode for example placed opposite the decoder that signals a temperature fault. When the temperature of 55°C is exceeded, the LED diode is red and the fan is controlled at the maximum speed. However, when the control system is found in the status described in step 3.7, namely, when the ambient sound volume is high and the fan is controlled at its maximum speed, the LED diode is green. In this manner, the user who can perceive that the fan is operating at maximum speed will not be concerned owing to the presence of the green colour.

Those skilled in the art can adapt the present invention into many other specific forms without moving away from the application domain of the invention as claimed. Consequently, the present embodiments must be considered as being examples but can be modified in the domain defined by the scope of the attached claims.

## Claims

1. A method for controlling a speed of a fan (5) comprised in an electronic device, the electronic device comprising an output for transmitting a sound signal, the method comprising the steps of:
- setting (3.3) the speed of the fan (5) to a first value;
- measuring (3.5) an amplitude of an ambient sound level with a microphone (8) included in a remote control dedicated to the electronic device;
- sending a signal representative of the measured amplitude of the ambient sound level from the remote control to the electronic device;
- increasing (3.7) the speed of the fan to a second value when the measured amplitude of the ambient sound level exceeds a threshold value;
- detecting an intention to reduce an amplitude of a sound signal transmitted by the device; and
- setting (3.3) the speed of the fan (5) to the first value in case an intention to reduce the amplitude of the sound signal is detected.

2. The method according to claim 1, wherein the intention to reduce the amplitude of the sound signal is detected by detecting an introduction of a command to reduce the amplitude of the sound signal.

3. The method according to claim 1, wherein the intention to reduce the amplitude of the sound signal is detected by detecting the reduction of an amplitude of a sound signal at an input or in a sound signal transmitting circuit of the device.

4. The method according to any one of the preceding claims, wherein
the second value of the speed of the fan is a function of the amplitude of the measured ambient sound level.

5. The method according to any one of the aforementioned claims, comprising a timeout step (3.10) triggered when the reduction of the amplitude of the sound signal transmitted by the device is detected, the end of the timeout triggering the execution of the effective reduction of the sound level emitted by the device.

6. The method according to any one of the preceding claims, wherein
the first speed of the fan is a function of a temperature measured in the device.

7. A system comprising an electronic device and a remote control, the electronic device comprising a fan (5), a controller (7) adapted to set a speed of said fan to a first value, and an output for transmitting a sound signal,
**characterized in that** the remote control comprises a microphone (8) for measuring an amplitude of an ambient sound level and an output for sending a signal representative of the measured amplitude of the ambient sound level to the electronic device,
**in that** the electronic device comprises a detection means adapted to detect an intention to reduce an amplitude of a sound signal transmitted by the device,
and **in that** the controller (7) further is adapted to increase (3.7) the speed of the fan to a second value when the measured amplitude of the ambient sound level exceeds a threshold value and to set (3.3) the speed of the fan (5) to the first value in case the detection means detects an intention to reduce the amplitude of the sound signal.

8. The system according to claim 7, **wherein** the detection means is adapted to detect the intention to reduce the amplitude of the sound signal by detecting an introduction of a command to reduce the amplitude of the sound signal.

9. The system according to claim 7, **wherein** the detection means is adapted to detect the intention to reduce the amplitude of the sound signal by detecting the reduction of an amplitude of a sound signal at an input or in a sound signal transmitting circuit of the device.

10. The system according to any one of claims 7 to 9, wherein the second value of the speed of the fan is a function of the amplitude of the measured ambient sound level.

11. The system according to any one of claims 7 to 10, comprising a timeout means triggered when the reduction of the amplitude of the sound signal transmitted by the device is detected, the end of the timeout triggering the execution of the effective reduction of the sound level emitted by the device.

12. The system according to any one of claims 7 to 11, **wherein** the first speed of the fan is a function of a temperature measured in the device.

## Patentansprüche

1. Verfahren zum Steuern einer Drehzahl eines Lüfters (5), der in einer elektronischen Vorrichtung enthalten ist, wobei die elektronische Vorrichtung einen Ausgang zum Senden eines Schallsignals umfasst, wobei das Verfahren die folgenden Schritte **umfasst:**
- Einstellen (3.3) der Drehzahl des Lüfters (5) auf einen ersten Wert;
- Messen (3.5) einer Amplitude eines Umgebungsschallpegels mit einem Mikrophon (8), das in einer für die elektronische Vorrichtung bestimmten Fernbedienung enthalten ist;
- Senden eines Signals, das die gemessene Amplitude des Umgebungsschallpegels repräsentiert, von der Fernbedienung an die elektronische Vorrichtung;
- Erhöhen (3.7) der Drehzahl des Lüfters auf einen zweiten Wert, wenn die gemessene Amplitude des Umgebungsschallpegels einen Schwellenwert übersteigt;
- Erfassen einer Absicht zum Verringern einer Amplitude eines Schallsignals, das durch die Vorrichtung gesendet wird; und
- Einstellen (3.3) der Drehzahl des Lüfters (5) auf den ersten Wert, falls eine Absicht zum Verringern der Amplitude des Schallsignals erfasst wird.

2. Verfahren nach Anspruch 1, **bei dem** die Absicht zum Verringern der Amplitude des Schallsignals durch Erfassen einer Eingabe eines Befehls zum Verringern der Amplitude des Schallsignals erfasst wird.

3. Verfahren nach Anspruch 1, **bei dem** die Absicht zum Verringern der Amplitude des Schallsignals durch Erfassen der Verringerung einer Amplitude eines Schallsignals an einem Eingang oder in einer Schallsignalsendeschaltung der Vorrichtung erfasst wird.

4. Verfahren nach einem der vorhergehenden Ansprüche, **bei dem** der zweite Wert der Drehzahl des Lüfters eine Funktion der Amplitude des gemessenen Umgebungsschallpegels ist.

5. Verfahren nach einem der obenerwähnten Ansprüche, das einen Zeitauslösungsschritt (3.10) umfasst, der ausgelöst wird, wenn die Verringerung der Amplitude des durch die Vorrichtung gesendeten Schallsignals erfasst wird, wobei das Ende der Zeitauslösung die Ausführung der effektiven Verringerung des durch die Vorrichtung ausgesendeten Schallpegels auslöst.

6. Verfahren nach einem der vorhergehenden Ansprüche, **bei dem** die erste Drehzahl des Lüfters eine Funktion einer in der Vorrichtung gemessenen Temperatur ist.

7. System, das eine elektronische Vorrichtung und eine Fernbedienung umfasst, wobei die elektronische Vorrichtung einen Lüfter (5), einen zum Einstellen einer Drehzahl des Lüfters auf einen ersten Wert ausgelegten Controller (7) und einen Ausgang zum Senden eines Schallsignals umfasst, **dadurch gekennzeichnet, dass** die Fernbedienung ein Mikrophon (8) zum Messen einer Amplitude eines Umgebungsschallpegels und einen Ausgang zum Senden eines Signals, das die gemessene Amplitude des Umgebungsschallpegels repräsentiert, an die elektronische Vorrichtung umfasst, dass die elektronische Vorrichtung ein Erfassungsmittel umfasst, das zum Erfassen einer Absicht zum Verringern einer Amplitude eines durch die Vorrichtung gesendeten Schallsignals ausgelegt ist,
und dass der Controller (7) ferner zum Erhöhen (3.7) der Drehzahl des Lüfters auf einen zweiten Wert, wenn die gemessene Amplitude des Umgebungsschallpegels einen Schwellenwert übersteigt, und zum Einstellen (3.3) der Drehzahl des Lüfters (5) auf den ersten Wert, falls das Erfassungsmittel eine Absicht zum Verringern der Amplitude des Schallsignals erfasst, ausgelegt ist.

8. System nach Anspruch 7, **bei dem** das Erfassungsmittel zum Erfassen der Absicht zum Verringern der Amplitude des Schallsignals durch Erfassen einer Eingabe eines Befehls zum Verringern der Amplitude des Schallsignals ausgelegt ist.

9. System nach Anspruch 7, **bei dem** das Erfassungsmittel zum Erfassen der Absicht zum Verringern der Amplitude des Schallsignals durch Erfassen der Verringerung einer Amplitude eines Schallsignals an einem Eingang oder in einer Schallsignalsendeschaltung der Vorrichtung ausgelegt ist.

10. System nach einem der Ansprüche 7 bis 9, **bei dem** der zweite Wert der Drehzahl des Lüfters eine Funktion der Amplitude des gemessenen Umgebungsschallpegels ist.

11. System nach einem der Ansprüche 7 bis 10, das ein Zeitauslösungsmittel umfasst, das ausgelöst wird, wenn die Verringerung der Amplitude des durch die Vorrichtung gesendeten Schallsignals erfasst wird, wobei das Ende der Zeitauslösung die Ausführung der effektiven Verringerung des durch die Vorrichtung ausgesendeten Schallpegels auslöst.

12. System nach einem der Ansprüche 7 bis 11, **bei dem** die erste Drehzahl des Lüfters eine Funktion einer in der Vorrichtung gemessenen Temperatur ist.

## Revendications

1. Un procédé de contrôle de la vitesse d'un ventilateur (5) compris dans un dispositif électronique, le dispositif électronique comprenant une sortie pour la transmission d'un signal sonore, le procédé **comprenant** les étapes suivantes :
- réglage (3.3) de la vitesse du ventilateur (5) sur une première valeur ;
- mesure (3.5) d'une amplitude d'un niveau sonore ambiant à l'aide d'un microphone (8) inclus dans une commande à distance dédiée au dispositif sonore ;
- envoi d'un signal représentatif de l'amplitude mesurée du niveau sonore ambiant de la commande à distance vers le dispositif électronique ;
- augmentation (3.7) de la vitesse du ventilateur vers une deuxième valeur lorsque l'amplitude mesurée du niveau sonore ambiant est supérieure à une valeur seuil ;
- détection d'une intention de réduire l'amplitude d'un signal sonore transmis par le dispositif ; et
- réglage (3.3) de la vitesse du ventilateur (5) sur la première valeur dans le cas où une intention de réduire l'amplitude du signal sonore est détectée.

2. Le procédé selon la revendication 1, **dans lequel** l'intention de réduire l'amplitude du signal sonore est détectée par la détection d'une introduction d'une commande pour réduire l'amplitude du signal sonore.

3. Le procédé selon la revendication 1, **dans lequel** l'intention de réduire l'amplitude du signal sonore est détectée par la détection de la réduction de l'amplitude d'un signal sonore lors d'une entrée ou dans un circuit de transmission du signal sonore du dispositif.

4. Le procédé selon l'une quelconque des revendications précédentes, **dans lequel** la deuxième valeur de vitesse du ventilateur est une fonction de l'amplitude du niveau sonore ambiant mesuré.

5. Le procédé selon l'une quelconque des revendications mentionnées ci-dessus, comprenant le déclenchement d'une étape de temporisation (3.10) lorsque la réduction de l'amplitude du signal sonore transmis par le dispositif est détectée, la fin de la temporisation déclenchant l'exécution de la réduction effective du niveau sonore émis par le dispositif.

6. Le procédé selon l'une quelconque des revendications précédentes, **dans lequel** la première vitesse du ventilateur est une fonction d'une température mesurée dans le dispositif.

7. Un système comprenant un dispositif électronique et une commande à distance, le dispositif électronique comprenant un ventilateur (5), un contrôleur (7) adapté pour régler une vitesse dudit ventilateur sur une première valeur, et une sortie pour transmettre le signal sonore,
**caractérisé en ce que** la commande à distance comprend un microphone (8) pour mesurer une amplitude d'un niveau sonore ambiant et une sortie pour envoyer un signal représentatif de l'amplitude mesurée du niveau sonore ambiant vers le dispositif électronique,
**en ce que** le dispositif électronique comprend un moyen de détection adapté pour détecter une intention de réduction de l'amplitude d'un signal sonore transmis par le dispositif
et **en ce que** le contrôleur (7) est en outre adapté pour augmenter (3.7) la vitesse du ventilateur sur une deuxième valeur lorsque l'amplitude mesurée du niveau sonore ambiant est supérieure à une valeur seuil et pour régler (3.3) la vitesse du ventilateur (5) sur la première valeur au cas où le moyen de détection détecte une intention de réduire l'amplitude du signal sonore.

8. Le système selon la revendication 7, **dans lequel** le moyen de détection est adapté pour détecter l'intention de réduire l'amplitude du signal sonore par la détection de l'introduction d'une commande pour réduire l'amplitude du signal sonore.

9. Le système selon la revendication 7, **dans lequel** le moyen de détection est adapté pour détecter l'intention de réduire l'amplitude du signal sonore en détectant la réduction de l'amplitude d'un signal sonore lors d'une entrée ou dans un circuit de transmission du signal sonore du dispositif.

10. Le système selon l'une quelconque des revendications 7 à 9, **dans lequel** la deuxième valeur de vitesse du ventilateur est une fonction de l'amplitude du niveau sonore ambiant mesuré.

11. Le système selon l'une quelconque des revendications 7 à 10, comprenant le déclenchement du moyen de temporisation lorsque la réduction de l'amplitude du signal sonore transmis par le dispositif est détectée, la fin de la temporisation déclenchant l'exécution de la réduction effective du niveau sonore émis par le dispositif.

12. Le système selon l'une quelconque des revendications 7 à 11, **dans lequel** la première vitesse du ventilateur est une fonction d'une température mesurée dans le dispositif.
